(19) **Europäisches Patentamt / European Patent Office / Office européen des brevets**

(11) **EP 0 966 036 B1**

(12) **EUROPEAN PATENT SPECIFICATION**

(45) Date of publication and mention
of the grant of the patent:
**26.11.2008 Bulletin 2008/48**

(51) Int Cl.:
*H01L 21/8234* (2006.01)  *H01L 21/8239* (2006.01)

(21) Application number: **99304134.2**

(22) Date of filing: **27.05.1999**

(54) **Method for fabricating a semiconductor device having different gate oxide layers**

Herstellungsverfahren für ein Halbleiterbauelement mit verschiedenen Gateoxidschichten

Procédé de fabrication d'un dispositif semi-conducteur avec des couches différentes d'oxyde de grille

(84) Designated Contracting States:
**DE FR GB NL**

(30) Priority: **15.06.1998 KR 9822434**

(43) Date of publication of application:
**22.12.1999 Bulletin 1999/51**

(73) Proprietor: **SAMSUNG ELECTRONICS CO., LTD.**
**Suwon,**
**Kyunggi-do (KR)**

(72) Inventors:
• **Yang, Won-Suk**
**Seocho-ku,**
**Seoul (KR)**
• **Kim, Ki-Nam**
**Dongahn-ku,**
**Ahnyang-shi,**
**Kyunggi-do (KR)**
• **Sim, Jai-Hoon**
**Kungnae-dong,**
**Kyunggi-do (KR)**
• **Lee, Jae-Kyu**
**Yongin-shi,**
**Kyunggi-do (KR)**

(74) Representative: **Mounteney, Simon James**
**Marks & Clerk**
**90 Long Acre**
**London**
**WC2E 9RA (GB)**

(56) References cited:
EP-A- 0 713 249       US-A- 5 371 026
US-A- 5 600 164       US-A- 5 756 385

• **WONG C Y ET AL: "SIDEWALL OXIDATION OF POLYCRYSTALLINE-SILICON GATE" IEEE ELECTRON DEVICE LETTERS,US,IEEE INC. NEW YORK, vol. 10, no. 9, 1 September 1989 (1989-09-01), pages 420-422, XP000087702 ISSN: 0741-3106**
• **PATENT ABSTRACTS OF JAPAN vol. 1996, no. 08, 30 August 1996 (1996-08-30) -& JP 08 107157 A (TOSHIBA MICROELECTRON CORP;TOSHIBA CORP), 23 April 1996 (1996-04-23) -& US 5 841 174 A (ARAI NORIHISA) 24 November 1998 (1998-11-24)**

EP 0 966 036 B1

**Description**

The present invention relates to a semiconductor device manufacturing method, and more particularly to a method for forming different gate oxide layers in a single chip.

The dimensions given in Angstroem (Å) throughout the description and the figures correspond to the SI-unit nanometer (nm) by the relation 10 Å =1 nm.

Recent trend toward high density integrated circuit increases chip density while decreases the size of the transistor built on the chip and gate oxide thickness.

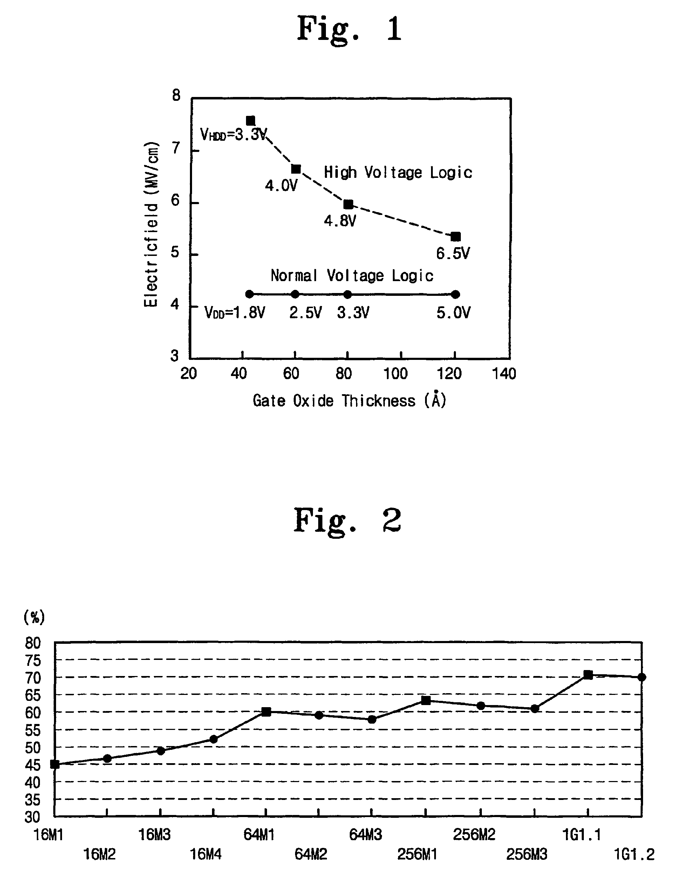

Fig.1 schematically shows the relationship between electrical field(MV/cm) and gate oxide thickness(Å) with respect to high voltage logic device and normal voltage logic device. As can be seen, the possibility of gate oxide breakdown increases with decrease in gate oxide thickness. To avoid this problem, supply voltage($V_{DD}$) which is required to operate the chip has been reduced. Since reduced supply voltage causes degradation of power and speed, the thickness of the gate oxide layer is required to be reduced to cope with this low power and speed.

As it is well known, the transistor characteristics can be increased by reducing gate oxide thickness while keeping the supply voltage at a constant level. On the other hand, the power consumption can be reduced by decreasing the supply voltage while keeping the gate oxide thickness at a constant level. Therefore, it is required that the gate oxide thickness be reduced without breakdown thereof while keeping a constant electric field which is so called "constant electric field scaling law".

It is the recent trend in the DRAM or MDL industry that chip areas occupied by the cell array is increasing. Therefore, if the gate oxide layer are formed to have the same thickness throughout the single chip, first of all the gate oxide at the cell array region is subject to suffering from breakdown. Furthermore, since voltage($V_{HDD}$) exceeding supply voltage($V_{DD}$) is supplied to the cell array interior, the electric filed applied thereto is increased and this intensifies the possibility of the gate oxide breakdown.

Since the cell density in the cell array region increases four folds per one generation, controlled threshold voltage is required against sub-threshold leakage and gate length variation, i.e., short channel effect margin is required. Besides short channel margin, drain saturation current($I_{DSAT}$) is required to be increased in the peripheral region.

To overcome above-mentioned problems, several methods have been disclosed. One of them is to increase the doping concentration in the channel region so as to adjust threshold voltage considering the short channel effect. The increase in the doping concentration, however, decreases breakdown margin and increases the threshold voltage variation for given gate length. In other words, gate length margins are reduced.

Another approach is to fabricate the cell array region and peripheral region on different chips, not on a single chip. This method, however, has a disadvantage of requiring process complexity and is not compatible with low-cost fabrication.

From EP 0 713 249 a method for forming semiconductor devices with oxide lasers having different thicknesses is known.

The present invention was made in view of the above problem, and discloses a method as recited in claim 1. It is therefore an object of the invention to provide a method for forming different gate oxide layers in a single chip and more particularly a method for forming different gate oxide layers after formation of the gate electrode. A key feature of this invention is to form different gate oxide layers through the oxidation process which is dependent on dimension of the active width. The active width dependent oxidation process is carried out after formation of the complete transistor (formation of the sidewall spacers).

Different dimension of the active areas(for example cell array region and peripheral region) are defined in and on the semiconductor substrate. A first thin gate oxide layer is formed on the overall active areas with a same thickness. Different gate patterns are formed over the thin oxide layer of the active areas. The gate patterns are crossing the active areas in parallel with width direction. In the narrow active region(cell array region) gate patterns are formed to have narrow distance between adjacent gate pattern while wide distance between adjacent gate patterns in the wide region (peripheral region). Gate spacers are formed on lateral edges of the patterned gates. Critical wet oxidation is carried out and thereby growing the thin oxide layer in the narrow active region(cell array region). The wet oxidation allows gate oxide growth to a greater extend in the narrow active region than wide active region(peripheral region). Thus, different gate oxide layers are formed in one chip, i.e., thick gate oxide layer in the cell array region and relatively thin gate oxide layer in the peripheral region.

During the oxidation process, oxidation along the gate length is not easily occurred while oxidant easily diffuses through the gate with which overlaps the field oxide layer. Therefore, if the active width is narrow(in the cell array region), the oxidant from the gate width direction(i.e., from the field oxide) grows thickly the thin gate oxide layer. On the other hand, if the active width is wide(in the peripheral region), amount of the oxidant from the gate width direction is small considering the active size, so that the thickness variation of the thin gate oxide layer is negligible. Accordingly, different gate oxide layers are formed in one chip.

The invention may be understood and its objects will become apparent to those skilled in the art by reference to the accompanying drawings as follows:

Fig.1 schematically shows the relationship between electrical field(MV/cm) and gate oxide thickness(Å) with respect to high voltage logic device and normal voltage logic device;

Fig.2 shows the relationship between degree of cell density and cell efficiency thereof;

Figs.3A and 3B illustrate top plan views of a semiconductor substrate where a plurality of gate patterns are formed intersecting active area surrounded by a filed oxide layer, respectively cell array region and peripheral region;

Figs.4A to 4B are cross-sectional views, respectively taken along line A-A' and line B-B' of Figs.3A before the formation of the gate pattern;

Figs.4C to 4D are cross-sectional views, respectively taken along line C-C' and line D-D' of Figs.3B before the formation of the gate pattern;

Figs.5A to 5D respectively illustrate a process step subsequent to that shown in Figs.4A to 4D wherein gate pattern is formed;

Figs.6A to 6D respectively illustrate a process step subsequent to that shown in Figs.5A to 5D wherein gate spacers are formed and then oxidation is carried out; and

Fig.7 shows the relationship between the thickness variation of the effective gate oxide and the active width under fixed gate pattern size(0.2 micrometers) by using the T-SUPREM4 and MEDICI(procell & device simulator).

A preferred embodiment of the present invention will now be described with reference to the accompanying drawings. The present invention relates to a method for forming different gate oxide layers in a single chip using active dimension dependent oxygen diffusivity. The effective gate oxide layer is completely formed after completely forming the gate pattern.

Fig.2 shows the relationship between degree of cell density and cell efficiency thereof. As can be seen, the degree of cell density is proportional to cell efficiency. As the cell density increases, the cell efficiency increases, too. That is because cell density increase in the cell array region while same circuit is used in the peripheral region. As the cell efficiency increases, gate oxide reliability arises easily in the cell array region due to larger electrical field than in the peripheral region. Therefore, it is needed a device that has a different gate oxide layers, i.e., thicker gate oxide in the cell array region and thin gate oxide layer in the peripheral region.

The present invention provides a high voltage device and a normal voltage device by more than 30% threshold voltage difference therebetween on a single chip. To this end, the high voltage device has a thicker gate oxide and the normal voltage device has a relatively thin gate oxide.

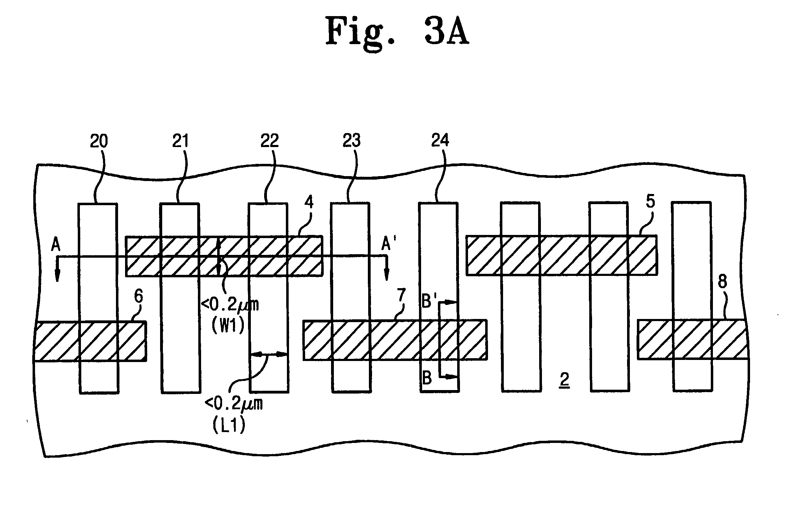

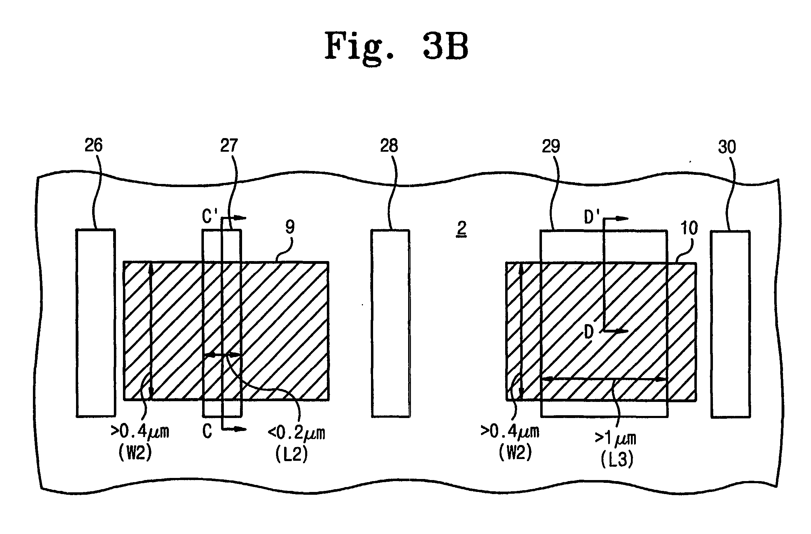

Figs.3A and 3B illustrate top plan views of a semiconductor substrate where a plurality of gate patterns are formed intersecting active area surrounded by a filed oxide layer, respectively cell array region and peripheral region.

Referring to Fig.3A, the gate patterns 20-24 intersects the active areas 4-8. Herein, active width is indicated by reference number "W1" and gate length is indicated by reference number "L1". As can be seen, active width("W1") in the cell array region is 0.2 micrometers or less and gate length("L1") is 0.2 micrometers or less. Reference number 2 represents the field oxide layer which surrounds the active areas 4-8.

Referring to Fig.3B, active areas 9 and 10 are surrounded by the filed oxide layer 2. The active areas 9 and 10 of the peripheral region has a wider active width( "W2") than that of the cell array region in Fig.3A. A plurality of gate patters 26-30 are formed running parallel with the active width direction. Herein, only one gate pattern are intersecting one active area. For example, the gate pattern 27 are intersecting the active area 9 and the gate pattern 29 are intersecting the active area 10. More than 90% of the active width("W2") of the peripheral region is at least two times as large as the cell array region(0.2 micrometers) and most of the active areas are 1.0 micrometers active width. The gate length of the gate patterns of the peripheral region is about 0.2 micrometers to 3.0 micrometers, and most of them are about 0.2 micrometers to 1.0 micrometers. For example, the gate pattern 27 has a gate length("L2") of about 0.2 micrometers and the gate pattern 29 has a gate length( "L3") of about 1.0 micrometers or more.

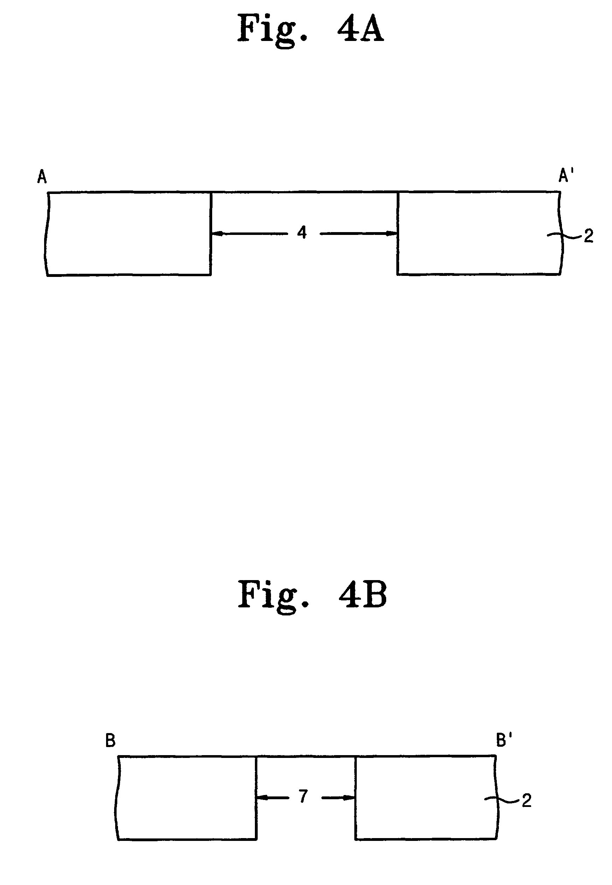

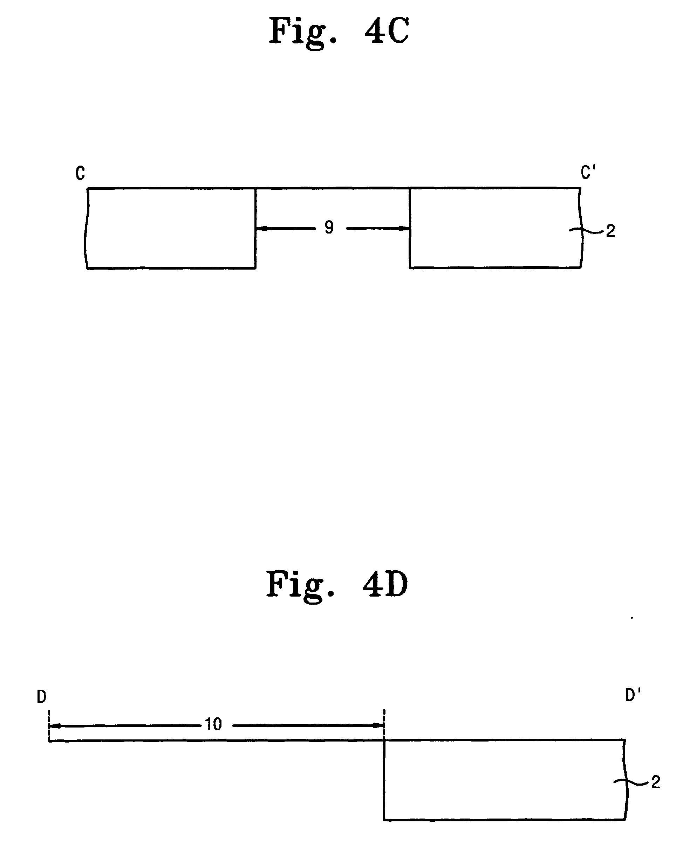

Figs.4A to 4B are cross-sectional views, respectively taken along line A-A' and line B-B' of Figs.3A before the formation of the gate pattern. Figs.4C to 4D are cross-sectional views, respectively taken along line C-C' and line D-D' of Figs.3B before the formation of the gate pattern.

Referring to Figs.4A to 4D, the field oxide layer 2 is formed to define active areas 4 and 7(cell array region, or high voltage region) and 9 and 10(peripheral region, or normal voltage region) on the semiconductor substrate (not shown). The active width("W1", 7) of the cell array region(see Fig.4B) is formed to be narrower than the active width ("W2", 9) of the peripheral region(see Fig.4C). As described early, the active width("W1") of the cell array region is about 0.2 micrometers or less and the active width("W2") of the peripheral region is about 0.4 micrometers or more.

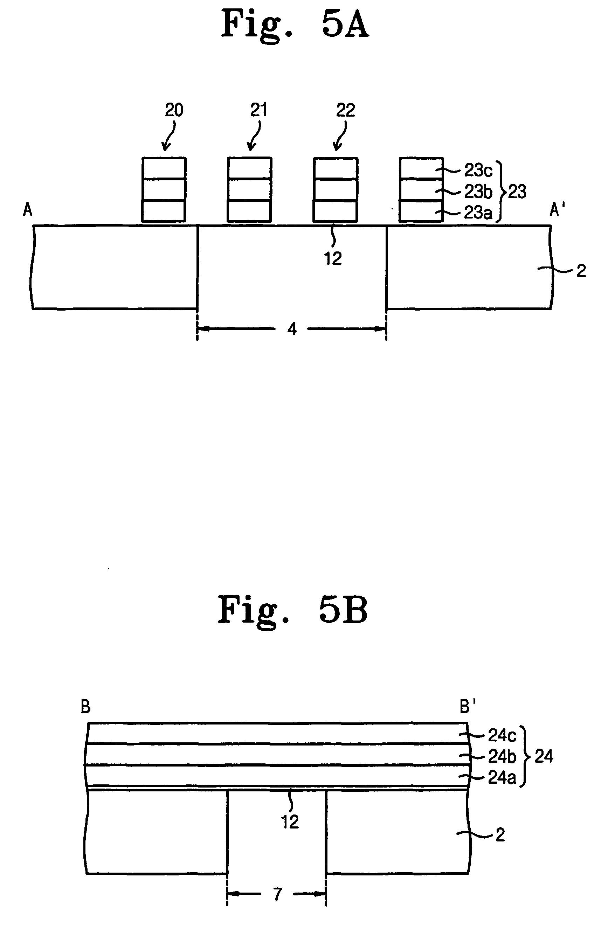

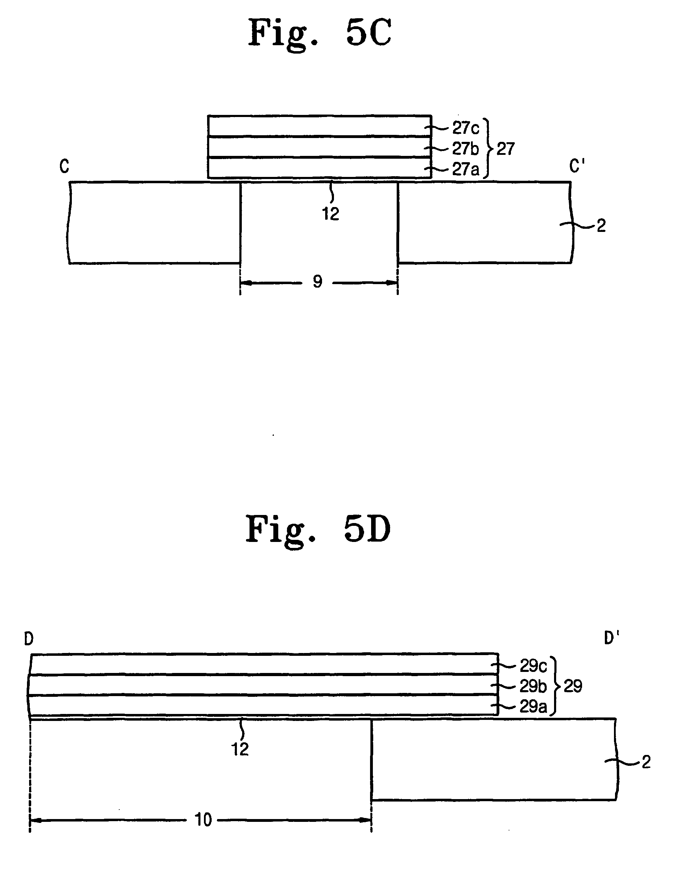

Figs.5A to 5D respectively illustrate a process step subsequent to that shown in Figs.4A to 4D wherein gate pattern is formed. After defining the active areas, conventional ion implanting process such as well ion implantation, field ion implantation, and channel ion implantation are carried out. Thereafter, first gate oxide layer 12 is formed over the entire semiconductor surface. The thickness of the first gate oxide is not affected by the active areas dimension. The gate oxide layer 12 is uniformly throughout the semiconductor surface. Stacked gate electrode patterns 20-24(cell array region) and 27 and 29(peripheral region) are formed. The gate patterns are formed by the process sequence of depositing doped polysilicon layers 23a, 24a, 27a, and 29a, suicide layers 23b, 24b, 27b, and 29b such as $WSi_x$, $TiSi_x$, and $MoSi_x$, hard mask layers 23c, 24c, 27c, and 29c such as $Si_3N_4$, HTO(high temperature oxide), PE-CVD(plasma enhanced chemical vapor deposition) oxide, and anti-reflection layer and then patterning to desired configuration by photo-etching process. The hard mask serves as etching mask and ion implanting mask. The gate patterns 20-24 of the cell array region have a gate length("L1") of about 0.2 microns or less. The gate patterns 27 and 29 of the peripheral region have a gate length of one and a half times as large as the cell array region, for example 0.2 micrometers to 3.0 micrometers, preferably most of them are 0.2 micrometers to 1.0 micrometers.

This anisotropic dry etching for gate patterning causes substrate damages and gate oxide encroachment at the bottom edges of the gate pattern. To cure the damage of the substrate and the gate oxide layer, gate poly oxidation process is carried out to form a second oxide layer(not shown) on the lateral edges of the gate patterns and on the surface of the semiconductor substrate outside of the gate patterns. At this time, bird's beak phenomenon is occurred in the bottom edges of the gate pattern so that the second oxide layer grows thickly. Electrical field are concentrated at the bottom edges of the gate patterns due to thicker oxide layer and thereby preventing degradation of the gate oxide.

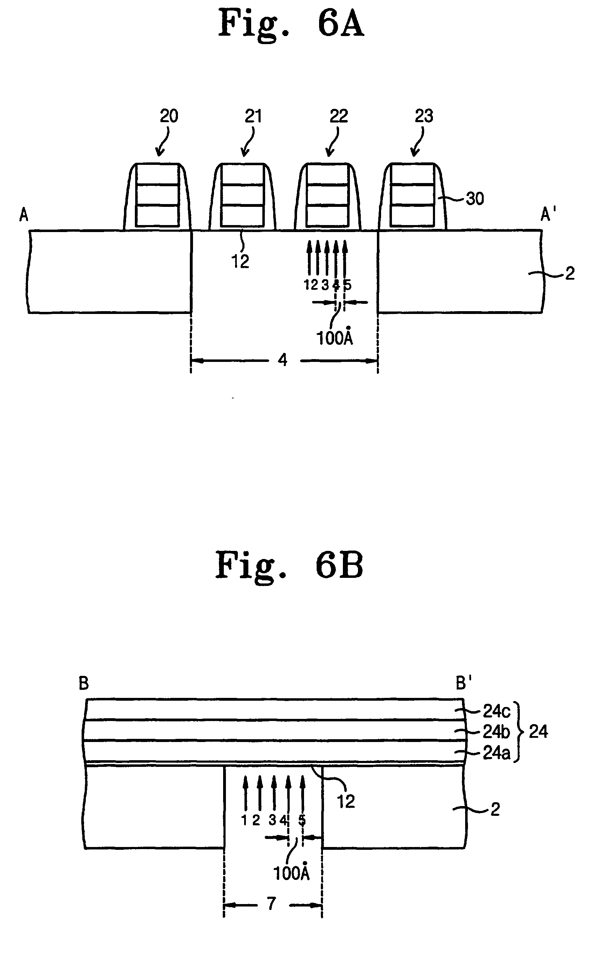

Figs.6A to 6D respectively illustrate a process step subsequent to that shown in Figs.5A to 5D wherein gate spacers are formed and then oxidation is carried out. Referring to Figs.6A to 6D, oxide spacers 30 are formed conventionally on the first oxide layer on lateral edges of the gate patterns 20-24,27 and 29. This oxide spacers 30 serve dual purpose of oxidation barrier layer in the subsequent wet oxidation and self aligned mask for ion implantation.

Subsequently, critical wet oxidation is carried out to form a third oxide layer(not shown) at a temperature of about 750°C to 850°C. Due to this wet oxidation, effective gate oxide thickness grows differently dependent on the active dimension(active width) and thereby forming different gate oxide layers in a single chip.

This wet oxidation allows different oxide layer growth according to the dimension of the active width. Oxide layer grows thickly in the cell array region while grows very thin in the peripheral region. This is because, during this wet oxidation, oxidant diffusivity from thick field oxide layer(active width direction) greatly affects the oxidation process while the oxidant diffusivity from gate oxide layer(gate length direction) is negligible in both cell array region and peripheral region. In other words, the oxidants from the gate length direction greatly affect the oxidation in the cell region with small active areas while affect nearly the oxidation in the peripheral region with large active areas. Accordingly, oxide layer in the cell array region grows thickly in both active width and gate length directions due to its narrow active width. On the other hand, oxide layer grows very thin in the peripheral areas due to its wide active width. Therefore, different gate oxide layers are formed in single chip.

Referring still to Figs.6A to 6D, there are provided five arrows(serial numbers 1 to 5) pointing out certain point of gate oxide layer. In Fig.6A taken along active length direction of the cell array region, the thickness of the gate oxide layer pointed by the arrows 1 to 5 is 107Å, 103Å, 100Å, 103Å, and 107Å, respectively. In Fig.6B taken along active width direction of the cell array region, the thickness of the gate oxide layer pointed by the arrows 1 to 5 is 110Å, 105Å, 100Å, 105Å, and 110Å, respectively. In Figs.6A and 6B, the distance between each arrow and the next is 100Å. Resulting gate oxide layer in the cell array region shown in Figs.6A and 6B is grown thickly as compared to before wet oxidation.

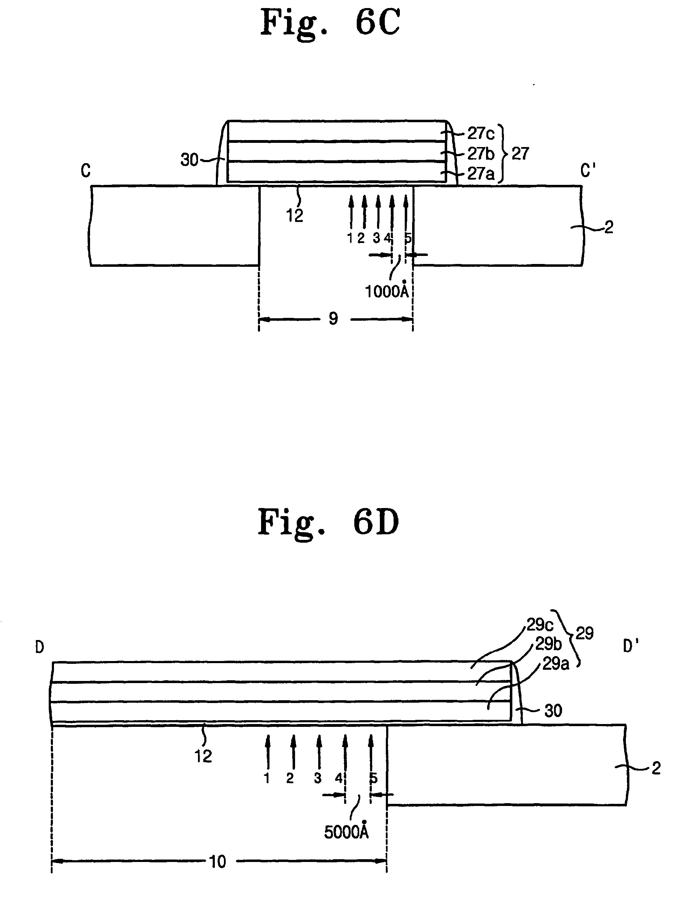

In Fig.6C taken along active width direction of the peripheral region, the thickness of the gate oxide layer pointed by the arrows 1 to 5 is 67Å, 67Å, 67Å, 75Å, and 107Å, respectively. In Fig.6D taken along active width direction of the peripheral region, the thickness of the gate oxide layer pointed by the arrows 1 to 5 is 60Å, 60Å, 60Å, 60Å, and 77Å, respectively. In Figs.6C and 6D, the distance between each arrow and the next is 1000Å and 5000Å, respectively. In the peripheral region, oxide layer grows thickly at bottom edges of the gate electrode and oxide layer except at the bottom edges is substantially same thickness as oxide layer before wet oxidation.

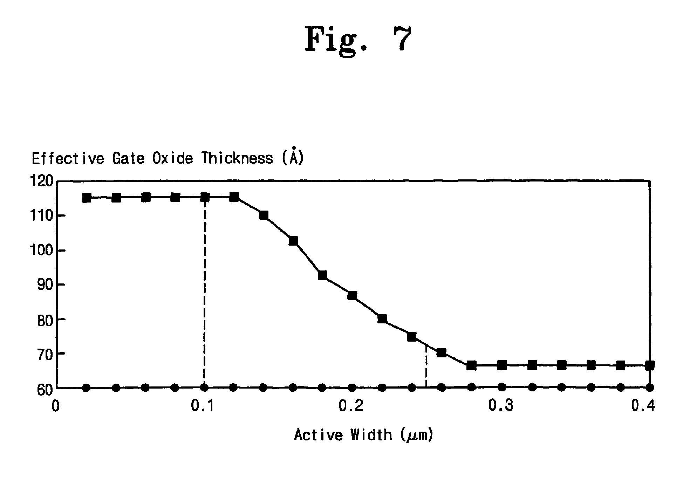

To better understand the current invention, Fig.7 is provided which shows the relationship between the thickness variation of the effective gate oxide and the active width under fixed gate pattern size(0.2 micrometers) by using the T-SUPREM4 and MEDICI(procell & device simulator). This simulation method was carried out under the condition that the gate pattern size is fixed at 0.2 micrometers and the wet oxidation is carried out on the bare wafer having 60Å oxide layer at a temperature about 780°C for 25minutes in 10 liters $H_2O$ atmosphere.

As can be seen, if the active width is more than 0.25 micrometers, the thickness variation is about 7Å due to small gate pattern size. If the active width is in the range between 0.25 micrometers and 0.1 micrometers, the oxide thickness significantly increases due to bird's beak phenomenon. If the active width is less than 0.1 micrometers, bird's beak phenomenon becomes severe to cause bird's beak punchthrough(oxidant punchthrough) phenomenon. The thickness of the oxide layer increase from initial 60Å to 115Å. This bird's beak punchthrough(oxidant punchthrough) region can be adjusted(i.e., can be shifted to a desired region) dependent on the wet oxidation condition.

Following equations(oxidation mechanism) is provide to explain the bird's beak punchthrough (oxidant punchthrough) phenomenon. Herein, it is noted that the silicon surface has a concave contour.

Stress($\sigma_x$) at the silicon-silicon oxide interface is given by

$$\sigma_x = \eta\xi(1/a^2 - 1/b^2) ---- [\text{equation } 1]$$

where $\eta$ is oxide viscosity, $\xi$ is velocity constant determined by oxide growth rate at the interface, a and b represents radius of coverture of oxide layer measuring respectively at upper surface and lower surface(facing the silicon substrate).

Oxide bulk hydrostatic pressure(P) is given by

$$P = \pm 2\,\eta\xi(1/b^2) -----[\text{equation } 2]$$

Diffusivity constant(D) by stress is given by

$$D = D^*_0 \exp(-P^* V_0/kT) ----[\text{equation } 3]$$

wherein P is bulk oxide stress

Solubility(C*) is given by

$$C = C^*_0 \exp(-P^* V_s/kT) ----[\text{equation } 4]$$

Surface reaction rate($K_s$) is given by

$$k_s = k_0\exp[\{-\sigma_x(\Omega_{SiO2} - \Omega_{si})\}/kT] ----[\text{equation } 5]$$

where $Q_{SiO2}$ is molecular volume and $\Omega_{si}$ is atom volume.

Since 60Å oxide layer is formed beneath the gate pattern along the gate length direction, stress is caused by volume expansion during oxidation process and such stress allows significant reduction in oxidant diffusivity. Therefore the increases in the oxide thickness is low. On the other hand, thick field oxide layer is formed beneath the gate pattern along the active width, the reduction of the oxidant diffusivity by volume expansion during oxidation process is very low. Therefore, the gate oxide layer grows thickly along the active width direction.

It is noted that this invention performs wet oxidation after formation of the insulating spacers so as to intensify the influence of the active width on oxide growth during oxidation. Namely, the insulating spacers serves to path of oxidation blocking.

Wet oxidation is preferably selected as oxidation ambient because wet oxidation has high solubility(more than 600 times as high as dry oxidation) and water($H_2O$) reacts with SiO to form hydroxyl group which breakdowns the $SiO_2$ and thereby reduces viscosity thereof. This reduces above mentioned bulk oxide stress and thereby increasing oxidation rate.

While this invention has been particularly shown and described with reference to the preferred embodiments thereof, it will be understood by those skilled in the art that various changes in form and details may be made without departing from the scope of this invention.

**Claims**

1. A method for simultaneously forming a first device and a second device respectively having first and second different gate oxide layers on a single chip, the first device being operable at a voltage higher.than that of the second device, said method comprising the steps of:

forming first and second active areas on a semiconductor substrate, the width (W1) of the first active area being less than that (W2) of the second active area;
forming first (20 to 24) and second (26 to 30) gate patterns on the first and second active areas respectively, said first gate pattern running parallel with the direction of the width of said first active area and said second gate pattern running parallel with the direction of the width of said second active area;

forming gate spacers (30) on side walls of each gate pattern; and **characterized by**

growing first and second gate oxide layers simultaneously beneath the first and second gate patterns respectively, wherein said first and second gate oxide layers are grown respectively at the first and second active areas, the first gate oxide layer being grown more thickly than the second gate oxide layer, whereby the first and second oxide layers constitute gate oxide layers of the first and second devices respectively.

**2.** A method according to claim 1, wherein the first active area with the narrower width is used as a cell array region and the second active area is used as a peripheral region.

**3.** A method according to claim 1, wherein the width of the first active area is about 0.2 micron and that of the second active area is about 0.4 micron or more.

**4.** A method according to claim 1, wherein the gate length of the second gate pattern is equal to or larger than that of the first gate pattern.

**5.** A method according to claim 1, wherein the gate length of the second gate pattern is at least 1.5 times as large as that of the first gate pattern.

**6.** A method according to claim 1, wherein the first active area width is about 0.2 micron and the wider second active area width is in the range of about 0.2 micron to 3 microns.

**7.** A method according to claim 1, wherein said gate spacers are made of an oxide layer.

**8.** A method according to claim 1, wherein the gate oxide layers are grown by a wet oxidation process.

**9.** A method according to claim 8, wherein said wet oxidation is carried out at a temperature in the range of about 700°C to 850°C.

**10.** A method according to claim 1, further comprising forming an oxide layer on said gate patterns and over said semiconductor substrate before said step of forming said gate spacers.

**11.** A method according to claim 10, wherein the said oxide layer is grown more thickly at lower and lateral edges of the said gate patterns than at other portions of the said gate patterns, so as to prevent an unacceptable electric field at said lower and lateral edges of said gate patterns.

**Patentansprüche**

**1.** Verfahren zum gleichzeitigen Bilden einer ersten Vorrichtung und einer zweiten Vorrichtung, die jeweils unterschiedliche erste und zweite Gate-Oxidschichten auf einem einzelnen Chipelement aufweisen, wobei die erste Vorrichtung bei einer Spannung betreibbar ist, die höher ist als die der zweiten Vorrichtung, wobei das Verfahren folgende Schritte beinhaltet:

Ausbilden von ersten und zweiten aktiven Bereichen auf einem Halbleitersubstrat, wobei die Breite (W1) des ersten aktiven Bereichs geringer ist als die (W2) des zweiten aktiven Bereichs;

Ausbilden von ersten (20 bis 24) und zweiten (26 bis 30) Gate-Strukturen auf jeweils den ersten und zweiten aktiven Bereichen, wobei die erste Gate-Struktur parallel mit der Richtung der Breite des ersten aktiven Bereichs verläuft und die zweite Gate-Struktur parallel mit der Richtung der Breite des zweiten aktiven Bereichs verläuft;

Ausbilden von Gate-Abstandshaltern (30) auf seitlichen Wänden einer jeweiligen Gate-Struktur; und **dadurch gekennzeichnet, dass**

erste und zweite Gate-Oxidschichten gleichzeitig unterhalb jeweils der ersten und zweiten Gate-Strukturen aufgewachsen werden, wobei die ersten und die zweiten Gate-Oxidschichten jeweils auf die ersten und zweiten aktiven Bereiche aufgewachsen werden, wobei die erste Gate-Oxidschicht dicker aufgewachsen wird als die zweite Gate-Oxidschicht, wodurch die ersten und die zweiten Oxidschichten Gate-Oxidschichten von jeweils den ersten und zweiten Vorrichtungen bilden.

**2.** Verfahren nach Anspruch 1, wobei der erste aktive Bereich mit der geringeren Breite als ein Zell-Array-Bereich verwendet wird und der zweite aktive Bereich als ein peripherer Bereich verwendet wird.

**3.** Verfahren nach Anspruch 1, wobei die Breite des ersten aktiven Bereichs etwa 0,2 Mikrometer aufweist und die des zweiten aktiven Bereichs etwa 0,4 Mikrometer oder mehr aufweist.

**4.** Verfahren nach Anspruch 1, wobei die Gate-Länge der zweiten Gate-Struktur größer oder gleich der der ersten Gate-Struktur ist.

**5.** Verfahren nach Anspruch 1, wobei die Gate-Länge der zweiten Gate-Struktur zumindest 1,5-mal so groß wie die der ersten Gate-Struktur ist.

**6.** Verfahren nach Anspruch 1, wobei die Breite des ersten aktiven Bereichs etwa 0,2 Mikrometer beträgt und die Breite des breiteren zweiten aktiven Bereichs im Bereich von etwa 0,2 Mikrometer bis 3 Mikrometer liegt.

**7.** Verfahren nach Anspruch 1, wobei die Gate-Abstandshalter aus einer Oxidschicht gebildet werden.

**8.** Verfahren nach Anspruch 1, wobei die Gate-Oxidschichten durch einen Nassoxidationsprozess aufgewachsen werden.

**9.** Verfahren nach Anspruch 8, wobei die Nassoxidation bei einer Temperatur im Bereich von etwa 700°C bis 850°C ausgeführt wird.

**10.** Verfahren nach Anspruch 1, ferner aufweisend ein Ausbilden einer Oxidschicht auf den Gate-Strukturen und über dem Halbleitersubstrat vor dem Schritt des Ausbildens der Gate-Abstandshalter.

**11.** Verfahren nach Anspruch 10, wobei die Oxidschicht an unteren und seitlichen Rändern der Gate-Strukturen dicker aufgewachsen werden als an anderen Bereichen der Gate-Strukturen, um ein inakzeptables elektrisches Feld an den unteren und seitlichen Rändern der Gate-Strukturen zu verhindern.

**Revendications**

**1.** Procédé en vue de former de manière simultanée un premier dispositif et un second dispositif ayant respectivement des première et seconde couches d'oxyde de grille distinctes sur une seule puce, le premier dispositif étant utilisable à un voltage supérieur à celui du second dispositif, ledit procédé comprenant les étapes de :

formation de première et seconde zones actives sur un substrat semi-conducteur, la largeur (W1) de la première zone active étant moindre que celle (W2) de la seconde zone active ;
formation de première (20 à 24) et seconde (26 à 30) configurations de grille sur les première et seconde zones actives respectivement, ladite première configuration de grille passant en parallèle à la direction de la largeur de ladite première zone active et ladite seconde configuration de grille passant en parallèle à la direction de la largeur de ladite seconde zone active ;
formation de cales d'espacement de grille (30) sur les parois latérales de chaque configuration de grille ; et
**caractérisé par**
le développement des première et seconde couches d'oxyde de grille de manière simultanée en dessous des première et seconde configurations de grille respectivement, dans lesquelles lesdites première et seconde couches d'oxyde de grille sont développées respectivement au niveau des première et secondes zones actives, la première couche d'oxyde de grille étant formée de manière plus épaisse que la seconde couche d'oxyde de grille, par le biais duquel les première et seconde couches d'oxyde constituent des couches d'oxyde de grille des premier et second dispositifs respectivement.

**2.** Procédé selon la revendication 1, dans lequel la première zone active avec la largeur rétrécie est utilisée en tant que région de réseau de cellule et la seconde zone active est utilisée comme région périphérique.

**3.** Procédé selon la revendication 1, dans lequel la largeur de la première zone active est d'environ 0,2 micron et celle de la seconde zone active est d'environ 0,4 micron ou plus.

4. Procédé selon la revendication 1, dans lequel la longueur de grille de la seconde configuration de grille est égale ou supérieure à celle de la première configuration de grille.

5. Procédé selon la revendication 1, dans lequel la longueur de grille de la seconde configuration de grille est au moins 1,5 fois plus grande que celle de la première configuration de grille.

6. Procédé selon la revendication 1, dans lequel la largeur de la première zone active est d'environ 0,2 micron et la largeur de la seconde zone active plus grande se situe environ entre 0,2 et 3 microns.

7. Procédé selon la revendication 1, dans lequel lesdites cales d'espacement sont faites d'une couche d'oxyde.

8. Procédé selon la revendication 1, dans lequel les couches d'oxyde de grille sont développées par un processus d'oxydation humide.

9. Procédé selon la revendication 8, dans lequel ladite oxydation humide est effectuée à une température située entre environ 700°C et 850°C.

10. Procédé selon la revendication 1, comprenant en outre la formation d'une couche d'oxyde sur lesdites configurations de grille et au-dessus dudit substrat semi-conducteur préalablement à ladite étape de formation de cales d'espacement.

11. Procédé selon la revendication 10, dans lequel ladite couche d'oxyde est développée de manière plus épaisse au niveau des bords inférieurs et latéraux desdites configurations de grille qu'au niveau d'autres parties desdites configurations de grille, de sorte à empêcher un champ électrique inacceptable au niveau des bords inférieurs et latéraux desdites configurations de grille.

# Fig. 1

# Fig. 2

# Fig. 3A

Fig. 3B

# Fig. 4A

A                                    A'

←  4  →       2

# Fig. 4B

B                        B'

←  7  →     2

# Fig. 4C

C  C'

9 ~ 2

# Fig. 4D

D  D'

10 ~ 2

# Fig. 5A

# Fig. 5B

# Fig. 5C

C — 27c
27b } 27
C' — 27a

12

2

9

# Fig. 5D

D — 29c
29b } 29
D' — 29a

12

2

10

# Fig. 6A

# Fig. 6B

# Fig. 6C

# Fig. 6D

# Fig. 7

Effective Gate Oxide Thickness (Å)

Active Width (μm)

**EP 0 966 036 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0713249 A